# EUROPÄISCHE PATENTSCHRIFT

(11) **EP 0 483 189 B1**
(45) Veröffentlichungstag und Bekanntmachung des Hinweises auf die Patenterteilung: **22.12.1993**
(21) Anmeldenummer: 90910592.6
(22) Anmeldetag: 12.07.1990
(51) Int. Cl.: G01R 15/07

(54) **FASEROPTISCHE ANORDNUNG ZUM MESSEN DER STÄRKE EINES ELEKTRISCHEN STROMES**
FIBRE OPTIC ARRANGEMENT FOR MEASURING THE STRENGTH OF AN ELECTRIC CURRENT
DISPOSITIF A FIBRES OPTIQUES POUR MESURER L'INTENSITE D'UN COURANT ELECTRIQUE

(30) Priorität: 19.07.1989 DE 3923804
(43) Veröffentlichungstag der Anmeldung: 06.05.1992
(73) Patentinhaber: MWB MESSWANDLER-BAU AG, D-96050 Bamberg (DE)
(72) Erfinder: PEIER, Dirk, D-4600 Dortmund 50 (DE); HIRSCH, Holger, D-4703 Bönen (DE)
(74) Vertreter: Hufnagel, Walter, Dipl.-Ing., Dipl.-Wirtsch.-Ing.
(86) Internationale Anmeldenummer: DE9000532
(87) Internationale Veröffentlichungsnummer: WO9101501

(56) Entgegenhaltungen:
- EP-A- 0 072 292
- US-A- 3 746 983

## Beschreibung

Die Erfindung betrifft eine faseroptische Anordnung zum Messen der Stärke eines elektrischen Stromes unter Ausnutzung des Faraday-Effekts, wobei das den auf Hochspannungspotential liegenden stromdurchflossenen Leiter umgebende Magnetfeld den Polarisationszustand des Lichts beeinflußt, dessen Weg durch den Kern einer optischen Faser führt, die den Leiter in Form einer Wicklung umgibt, wobei an dem einen Ende der optischen Faser eine reflektierende Fläche vorgesehen ist, während an ihrem anderen Ende die Ein- und Auskopplung des Lichts erfolgt.

Derartige Anordnungen werden insbesondere in Hochspannungsanlagen eingesetzt, um Ströme in auf Hochspannungspotential liegenden Leitungen zu messen. Da die Lichtwellenleiter aus Glas bestehen, das bekanntlich ein guter elektrischer Isolator ist, gibt es keine Probleme bezüglich der Isolierung der mit Erdpotential verbundenen Anzeigegeräte gegenüber den auf Hochspannungspotential liegenden Leitern, deren Strom gemessen und angezeigt werden soll.

Aus der DE-AS 22 61 151 ist eine derartige Anordnung bekannt, bei der von einer Lichtquelle Licht durch einen Polarisator auf eine halbdurchlässige Platte gelenkt wird. Von dort gelangt das polarisierte Licht in eine optische Faser (dort "Lichtwellenleiter" genannt), die teilweise zu einer Spule gewickelt ist, in deren Achse ein Hochspannungsleiter verläuft, in welchem der zu messende Strom fließt. Diese Faserspule ist an ihrem Ende mit einer verspiegelten Fläche versehen oder es ist dort ein Spiegel angeordnet. Das polarisierte Licht durchläuft die gesamte optische Faser, wobei innerhalb des spulenförmigen Teils der Faser aufgrund des Faraday-Effekts eine Drehung der Polarisationsebene in Abhängigkeit von dem Magnetfeld erfolgt, das der in dem Leiter fließende Strom erzeugt. Am Ende der Spule wird der Lichtstrahl reflektiert und durchläuft noch einmal die Spule, wobei eine weitere Drehung der Polarisationsebene eintritt. Das in seiner Polarisationsebene gedrehte Licht tritt aus der optischen Faser aus, durchsetzt die halbdurchlässige Platte und gelangt in eine Auswerteeinrichtung, die den Winkel zwischen der Polarisationsebene des in die optische Faser eintretenden Lichts und der Polarisationsebene des aus der Faser austretenden Lichts feststellt und anzeigt, wobei die Größe dieses Winkels dem Wegintegral über der magnetischen Feldstärke proportional ist.

Aus der DE-AS 28 35 794 ist ebenfalls eine faseroptische Anordnung zum Messen der Stärke eines elektrischen Stromes unter Ausnutzung des Faraday-Effekts bekannt, wobei das den stromdurchflossenen Leiter umgebende Magnetfeld den Polarisationszustand des Lichts beeinflußt, dessen Weg durch den Kern einer optischen Faser führt, die den Leiter in Form einer Wicklung umgibt. Im Gegensatz zu der DE-AS 22 61 151 ist bei dieser Anordnung an dem einen Ende der Faser keine reflektierende Fläche vorgesehen, vielmehr wird das Licht an dem einen Ende eingekoppelt und an dem anderen wieder ausgekoppelt, wobei die aus der optischen Faser gewickelte Spule die doppelte Windungszahl haben muß, um die gleichen Drehwinkel der Polarisationsebene zu erhalten, weil die Spule nur einmal von dem Licht durchlaufen wird.

Sowohl aus dieser bekannten Anordnung als auch aus der EP-OS 0 072 292 sowie aus dem Aufsatz "Magneto-optic current sensing with birefringent fibers" von S. C. Rashleigh und R. Ulrich, veröffentlicht in Appl. Phys. Lett. 34 (11) vom 1. Juni 1979, ist es ferner bekannt, der optischen Faser durch Verdrillen um ihre Längsachse eine zirkulare Doppelbrechung aufzuprägen, wodurch der nachfolgend beschriebene Nachteil, der durch die spulenförmige Aufwicklung der optischen Faser entsteht, kompensiert wird. Durch die notwendige Biegung der Faser beim Wickeln zu einer Spule wird der Querschnitt der Faser elliptisch verformt, wodurch der Faser eine erhebliche lineare Doppelbrechung aufgeprägt wird, die die Wirkung des Faraday-Effekts herabsetzt und in ungünstigen Fällen dazu führen kann, daß der Faraday-Effekt nicht mehr meßbar bzw. eindeutig erkennbar ist. Durch die durch das Verdrillen der Faser bewirkte zirkulare Doppelbrechung wird erreicht, daß die insgesamt vorhandene lineare Doppelbrechung nur noch als eine Störung an der insgesamt vorhandenen zirkularen Doppelbrechung zu betrachten ist, so daß sie den Faraday-Effekt nicht mehr nennenswert beeinflußt, der somit voll wirksam werden kann.

Es hat sich gezeigt, daß bei gleichzeitiger Anwendung der Lehren aus den vorstehend erläuterten bekannten Druckschriften, nämlich bei einer faseroptischen Anordnung, bei der eine um ihre Längsachse verdrillte optische Faser einen auf Hochspannungspotential liegenden Leiter in Form einer Wicklung umgibt, an deren Ende eine reflektierende Fläche, und zwar ebenfalls auf Hochspannungspotential, vorzusehen, während an dem anderen Ende der Faser die Ein- und Auskopplung des Lichts erfolgt, immer noch unzulässig hohe Meßfehler auftreten, die in ungünstigen Fällen einen Betrag von mehr als 100 % erreichen können.

Es ist zwar aus der US-PS 3,746,983 eine faseroptische Anordnung zum Messen der Stärke eines elektrischen Stromes unter Ausnutzung des Faraday-Effekts bekannt, bei der das den stromdurchflossenen Leiter umgebende Magnetfeld den Polarisationszustand des Lichts beeinflußt, dessen Weg durch den Kern einer optischen Faser führt, die jedoch den Leiter nicht in Form einer Spule, sondern in Form nur einer einzigen Windung umgibt, deren Enden sich antiparallel zueinander im Bereich des die Hochspannung führenden Leiters befinden und die durch magnetische Streufelder entstehende zusätzliche Drehungen der Polarisationsebene des Lichts in der Faser vermeidet. Wie jedoch das Licht von dem Polarisationsfilter zu dem einen Ende der optischen Faser und von dem anderen zu der Auswerteeinrichtung gelangt, ist nicht angegeben. Entweder müßten diese Einrichtungen ebenfalls an dem die Hochspannung führenden Leiter angeordnet werden oder es müßten die Enden durch Verlängerungen der Faser an diese Einrichtungen herangeführt werden, so daß die magnetischen Streufelder die Polarisationsebene des Lichts zusätzlich verdrehen können, was gerade vermieden werden soll.

Der Erfindung liegt die Aufgabe zugrunde, eine faseroptische Anordnung der eingangs erwähnten Art zu schaffen, die die Vorteile des Verdrillens der optischen Faser ausnutzt und gleichzeitig alle weiteren Meßfehler reduziert.

Diese Aufgabe wird nach dem Kennzeichen des einzigen Patentanspruchs dadurch gelöst, daß der optischen Faser durch Verdrillen um ihre Längsachse eine zirkulare Doppelbrechnung aufgeprägt ist, daß das eine Ende der optischen Faser mit der reflektierenden Fläche in unmittelbarer Nähe ihres anderen Endes angeordnet ist, so daß die gesamte optische Faser einen nahezu vollständig in sich geschlossenen Weg darstellt und daß beide Endabschnitte der optischen Faser unmittelbar benachbart und parallel zueinander liegen.

Die mit der Erfindung erzielten Vorteile bestehen insbesondere darin, daß durch den in sich geschlossenen Weg der optischen Faser das Durchflutungsgesetz anwendbar ist und die magnetischen Streufelder sowohl des Leiters, dessen Strom gemessen werden soll, als auch etwaiger benachbarter Leiter keine zusätzlichen, das Meßergebnis verfälschenden Drehungen der Polarisationsebene des Lichts in der optischen Faser hervorrufen können.

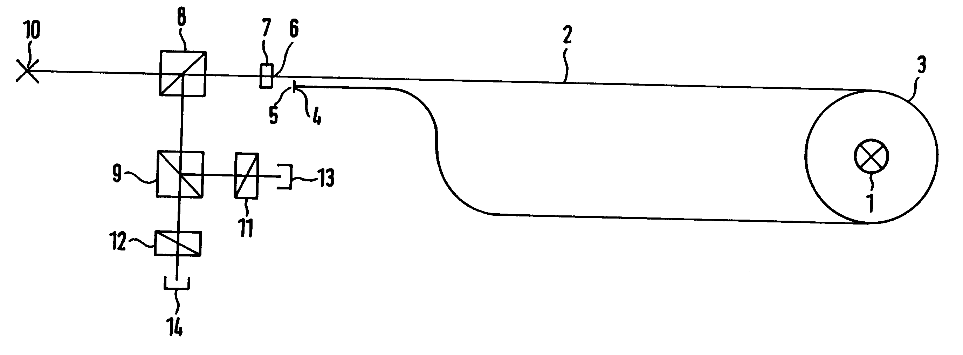

Ein Ausführungsbeispiel ist in der Zeichnung dargestellt und wird im folgenden näher beschrieben.

Die faseroptische Anordnung zum Messen der Stärke eines elektrischen Stromes besteht aus einer um ihre Längsachse verdrillten optischen Faser 2, die sich von ihrem einen Ende 6, das an einer Linse 7 angeordnet ist, zu einem auf Hochspannungspotential liegenden Leiter 1 erstreckt, diesen Leiter 1 als Wicklung 3 mit einer Anzahl nebeneinander angeordneter Windungen umgibt und wieder zurück in die Nähe der Linse 7 verläuft, wo ihr Ende 4 eine verspiegelte Fläche 5 aufweist, die rechtwinklig zu der Faserlängsachse ausgerichtet ist.

Die Linse 7 koppelt das über einen Strahlenteiler 8 kommende, von einem Laser 10 ausgestrahlte, polarisierte Licht in das eine Ende 6 der optischen Faser 2 ein. Innerhalb des zur Wicklung 3 geformten Teils der optischen Faser 2 ist der Lichtwellenleiter einem Magnetfeld ausgesetzt, das von dem durch den Leiter 1 fließenden Strom erzeugt wird. Aufgrund des Faraday-Effekts wird die Polarisationsebene des geführten Lichts während des Durchlaufens der Wicklung 3 und somit des Magnetfeldes gedreht, wobei die Größe des Drehwinkels ein Maß für das Wegintegral über der magnetischen Feldstärke ist.

Hinter der Wicklung 3 gelangt das Licht weiter über die optische Faser bis zu ihrem anderen Ende 4, wo es an der verspiegelten Endfläche 5 reflektiert wird, so daß es den Weg durch die optische Faser 2 und durch das Magnetfeld im Bereich der Wicklung 3 in entgegengesetzter Richtung durchläuft, wobei die Polarisationsebene abermals gedreht wird, so daß der Drehwinkel der Polarisationsebene beim Eintreffen des Lichts an der Linse 7 gegenüber dem Drehwinkel beim Eintreffen des Lichts an der verspiegelten Endfläche 5 insgesamt verdoppelt ist.

Die Ein- und Auskopplung des Lichts erfolgt über die Linse 7. Beim Auskoppeln gelangt das Licht aus der optischen Faser 2 über den Strahlenteiler 8 zu einer Auswerteeinrichtung, die aus einem weiteren Strahlenteiler 9, aus zwei Polarisatoren 11, 12 und zwei Photodetektoren 13, 14 besteht, in der der Drehwinkel ermittelt wird, den die Polarisationsebene des Lichts beim Durchgang durch die optische Faser 2 erfahren hat und der ein Maß für die Stärke des in dem Leiter 1 fließenden elektrischen Stromes ist.

Die Meßfehler sind vernachlässigbar klein, da einerseits durch das Verdrillen der optischen Faser 2 der Einfluß der linearen Doppelbrechung beseitigt ist und andererseits durch den in sich geschlossenen Weg der optischen Faser 2 die magnetischen Streufelder sowohl des Leiters 1, dessen Strom gemessen werden soll, als auch etwaiger benachbarter Leiter keine zusätzlichen Drehungen der Polarisationsebene des Lichts in der optischen Faser 2 hervorrufen können.

## Patentansprüche

1. Faseroptische Anordnung zum Messen der Stärke eines elektrischen Stromes unter Ausnutzung des Faraday-Effekts, wobei das den auf Hochspannungspotential liegenden stromdurchflossenen Leiter (1) umgebende Magnetfeld den Polarisationszustand des Lichts beeinflußt, dessen Weg durch den Kern einer optischen Faser (2) führt, die den Leiter (1) in Form einer Wicklung (3) umgibt, wobei an dem einen Ende (4) der optischen Faser (2) eine reflektierende Fläche (5) vorgesehen ist, während an ihrem anderen Ende (6) die Ein- und Auskopplung des Lichts erfolgt,
dadurch gekennzeichnet, daß der optischen Faser (2) durch Verdrillen um ihre Längsachse eine zirkulare Doppelbrechung aufgeprägt ist, daß das eine Ende (4) der optischen Faser (2) mit der reflektierenden Fläche (5) in unmittelbarer Nähe ihres anderen Endes (6) angeordnet ist, so daß die gesamte optische Faser (2) einen nahezu vollständig in sich geschlossenen Weg darstellt und daß beide Endabschnitte der optischen Faser (2) unmittelbar benachbart und parallel zueinander liegen.

## Claims

1. A fibre optics arrangement for measuring the strength of an electric current using the Faraday effect, wherein the magnetic field surrounding the current-carrying conductor (1), which is connected to high voltage potential, influences the polarization state of the light, the path of which leads through the core of an optical fibre (2) which surrounds the conductor (1) in the form of a winding (3), wherein a reflecting surface (5) is provided at one end (4) of the optical fibre (2), while the input-coupling and output-coupling of the light takes place at the other end (6) of the optical fibre, characterised in that circular double refraction is impressed upon the optical fibre (2) by twisting it about its longitudinal axis, that the one end (4) of the optical fibre (2) is arranged with the reflecting surface (5) in the direct vicinity of its other end (6) in such manner that the whole optical fibre (2) represents a virtually completely closed path, and that the two end portions of the optical fibre (2) extend directly adjacent and in parallel to one another.

## Revendications

1. Dispositif à fibres optiques pour mesurer l'intensité d'un courant électrique en utilisant l'effet Faraday, dispositif dans lequel le champ magnétique entourant le conducteur (1) parcouru par le courant sous haute tension influence l'état de polarisation de la lumière, dont le chemin passe à travers le coeur d'une fibre optique (2), qui entoure le conducteur (1) sous forme d'un enroulement (3), une surface réfléchissante (5) étant prévue sur l'une des extrémités (4) de la fibre optique (2), tandis qu'à son extrémité (6) a lieu le couplage et le découplage de la lumière, dispositif à fibres optiques caractérisé en ce que la fibre optique (2) est empreinte par torsion autour de son axe longitudinal d'une biréfringence circulaire, que l'une des extrémités (4) de la fibre optique (2) est disposée avec la surface réfléchissante (5) à proximité immédiate de son autre extrémité (6), de telle sorte que toute la fibre optique (2) constitue un chemin presque complètement fermé en soi, et que les deux sections terminales de la fibre optique (2) se trouvent directement voisines et parallèles l'une à l'autre.
